Europäisches Patentamt

European Patent Office

Office européen des brevets

(11) Publication number: **0 437 090 A1**

# EUROPEAN PATENT APPLICATION

(21) Application number: 90314226.3

(51) Int. Cl.⁵: **B41M 5/155**, G03F 7/00

(22) Date of filing: **24.12.90**

(30) Priority: **08.01.90 US 461729**

(43) Date of publication of application:
**17.07.91 Bulletin 91/29**

(84) Designated Contracting States:
**DE FR GB**

(71) Applicant: **THE MEAD CORPORATION**
**2000 Courthouse Plaza NE**
**Dayton Ohio 45463(US)**

(72) Inventor: **Amick, Trude**
**9, Linwood Drive**
**Chillicothe, Ohio(US)**

(74) Representative: **Deans, Michael John Percy et al**
**Lloyd Wise, Tregear & CO. Norman House**
**105-109 Strand**
**London WC2R OAE(GB)**

(54) Developer material including styrene-maleic anhydride copolymer and reactive organic acid.

(57) A developer material produced by the process comprising the steps of:
mixing and melting together a developer composition comprising esterfied or hydrolyzed styrene-maleic anhydride copolymer and an organic acid or metal salt threof capable of reacting with a chromogenic electron donating colorless precursor to form a visible image;
cooling said melted mixture to form a solid material is disclosed; and
dispersing said solid material in a coating medium. The developer sheet is particularly useful in photosensitive imaging systems.

EP 0 437 090 A1

## DEVELOPER MATERIAL INCLUDING STYRENE-MALEIC ANHYDRIDE COPOLYMER AND REACTIVE OR-GANIC ACID

The present invention relates to a developer material, and, more particularly, a developer material produced by mixing and melting together a partially esterfied fully hydrolyzed styrene-maleic anhydride copolymer and an organic acid and/or metal salt of organic acid capable of reacting with a chromogenic electron donating colorless precursor to form a visible image. The developer material is capable of producing high density images and does not yellow upon aging and has excellent coating properties.

The developer material of the present invention can be used in conjunction with conventional pressure-sensitive copy paper or photosensitive imaging systems employing microcapsules to provide visible images upon contact with a color precursor which is released from the microcapsules and transferred to the developer sheet. Pressure-sensitive copy paper is well known in the art. It is described in U.S. Patents 2,712,507; 3,016,308; 3,170,809; 3,455,721; 3,466,184; 3,672,935; 3,955,025; and 3,981,523.

Photosensitive imaging systems employing microencapsulated radiation sensitive compositions are the subject of commonly assigned U.S. Patent Nos. 4,399,209 and 4,440,846 to The Mead Corporation. These imaging systems are characterized in that an imaging sheet including a layer of microcapsules containing a photosensitive composition in the internal phase is image-wise exposed to actinic radiation. In the most typical embodiments, the photosensitive composition is a photopolymerizable composition including a polyethylenically unsaturated compound and a photoinitiator which is encapsulated with a color precursor. Exposure image-wise hardens the internal phase of the microcapsules. Following exposure, the imaging sheet is subjected to a uniform rupturing force by passing the sheet through the nip between a pair of pressure rollers.

U.S. Patent No. 4,399,209 discloses a transfer system in which the imaging sheet is assembled with a developer sheet prior to being subjected to the rupturing force. Upon passing through the pressure rollers in contact with the developer sheet, the microcapsules rupture and image-wise release the internal phase whereupon the color former migrates to the developer sheet where it reacts with a dry developer and forms a color image. The imaging system can be designed to reproduce monochromatic or polychromatic full color images. U.S. patent 4,440,846 discloses a self contained system in which the color precursor is released in a developer layer on the same surface of the imaging sheet.

In a typical embodiment, the chromogenic color-forming agent is an electron donating compound and the developer material is an electron accepting compound. Developer materials which are capable of reacting with electron donating chromogenic color precursors are known in the art. For example, one developer material used comprises the product of oxidative coupling of substituted or unsubstituted phenols or bisphenols. Examples of such developers are described in commonly assigned U.S. Patent No. 4,647,952.

Another class of electron accepting developer materials are vinyl developer resins. These materials are described in commonly assigned U.S. Patent No. 4 877,767 These developer resins are acrylic, methacrylic or vinyl polymers having pendant developer moieties, such as pendant hydroxy aromatic or aromatic acid moieties which are preferably metallated.

Commonly assigned U.S. Patent No 4,859,561 provides a developer sheet including a developer material which is capable of coalescing into a thin continuous film after development. According to the teachings of the reference, the developer materials are film forming, thermoplastic, phenolic resins.

Commonly assigned U.S. Patent Application Serial No. 259,074, filed October 18, 1988, and Japan 1-271436 also describes a developer sheet which is capable of provided transparencies or reproductions having a gloss finish. According to this reference, the developer material comprises the combination of a finely divided thermoplastic resin which is capable of glossing and a non-resinious developer material.

Despite the success of these developer materials, they still can suffer from slight defects, such as yellowing upon aging. In addition, some individuals are sensitive to phenolic type developer resins. Accordingly, alternatives to the above described developer materials are being considered.

U.S. Patent No. 3,874,895 to Fuji Photo Film Co. discloses a recording sheet. The recording sheet comprises a support having thereon a color developer layer capable of reacting with a color former to form a color image. The color developer layer comprises an acidic polymer and an organic carboxylic acid or a metal salt thereof. To produce the developer sheet, the acid polymer and the carboxylic acid are mixed together, dispersed in a binder and coated onto the developer support. Examples of acid polymers disclosed in this patent include partially or completely hydrolyzed styrene-maleic anhydride copolymers, and examples of organic acids disclosed include salicylic acids and derivatives thereof, included metallated salicylic acids such as zinc salicylate.

The present invention provides a developer material and sheet which is capable of producing high density images which do not yellow upon aging. In addition, the developer materials are capable of coalescing into a thin continuous film upon the application of heat and/or pressure. This material is useful in carbonless paper or imaging systems of the type described in U.S. Patent 4,399,209.

In accordance with one embodiment of the present invention, a developer material is provided. The material is produced by the process comprising the steps of:

mixing and melting together a developer composition comprising an esterfied or hydrolyzed styrene-maleic anhydride copolymer and an organic acid and/or metal salt of an organic acid capable of reacting with a chromogenic electron donating colorless precursor to form a visible image;

cooling said melted mixture to form a solid material; and

dispersing said solid material in a coating solvent.

In a particularly preferred embodiment, the organic acid is salicylic acid or a metallated salt thereof such as zinc salicylate. Further, the compositions may include other additives such as ultraviolet absorbers, antioxidants, binders, and the like.

While not wishing to be bound by any theory, the inventors hypothesize that critical to the success of the present invention is that the styrene-maleic anhydride copolymer and organic acid be melted together prior to formation as a final solid developer material. For example, as discussed above, U.S. Patent No. 3,874,895 assigned to Fuji Photo Film Co. discloses a developer material which includes similar components to that of the present invention (i.e., styrene-maleic anhydride copolymer, salicylic acid and zinc salicylate). This reference only teaches mixing the materials together in contrast to melting them, as is done in the present invention. By melting the materials together, the resulting developer material may be coated much more easily at high solids levels than the developer disclosed in U.S. Patent No. 3,874,895 as the developer material according to the present invention has a much lower viscosity.

In accordance with another embodiment of the present invention a developer sheet is provided. The sheet comprises a support having a layer of the above-defined color developer material on the surface thereof.

In still another embodiment, a process for forming images is provided, the process comprising the step of image-wise transferring a chromogenic colorless electron donating color-forming agent to a developer sheet having a layer of the above-defined color developer material.

In a particularly preferred embodiment, the chromogenic colorless electron donating color-forming agent is transferred to the developer sheet via a photosensitive imaging sheet which includes microcapsules which have as their internal phase the color-forming agent as well as a composition which undergoes a change in viscosity upon exposure to atonic radiation. Further, to produce a glossy or transparentized image, the developer sheet, after transfer, may be subjected to heat and/or pressure to coalesce the developer material into a thin continuous film.

Thus, an object of the present invention is to provide a developer material which is capable of producing high density images, does not yellow upon aging, is easily coatable and is capable of coalescing into a thin continuous film.

This, and other objects will be readily understood by those skilled in the art as reference is made to the detailed description of the preferred embodiment.

While describing the preferred embodiment, certain terminology will be utilized for the sake of clarity. The use of such terminology is intended to encompass all technical equivalents which operate in a similar manner, for a similar purpose, to obtain a similar result.

The present invention provides a novel developer material which is capable of providing high density images, is resistant to yellowing upon aging, may be easily coated at high solids levels and is capable of coalescing into a thin transparent continuous film upon the application of heat and/or pressure.

The developer material may be used in any transfer system containing a donor or imaging sheet and a developer sheet wherein the donor or imaging sheet contains an image-forming agent capable of reacting with the developer material to form an image, and wherein, to produce a visible image, the donor or imaging sheet is assembled with the developer sheet and pressure is applied to the sheets to cause transfer of the image-forming agent to the developer sheet. The developer material may also be utilized in a self-contained imaging format. It is particularly envisioned that the developer material and sheet of the present invention be used in association with imaging sheets containing photosensitive microcapsules containing an image-forming agent. However, it is envisioned that the inventive developer sheet may be used in association with any transfer image-forming system.

To produce the developer material of the present invention an esterfied or hydrolyzed styrene-maleic anhydride copolymer and an organic acid and/or metal salt of an organic acid capable of reacting with a chromogenic electron donating color precursor are mixed together and then melted together to form a unitary mass. The mass comprises a highly viscous molten liquid. The molten liquid is then cooled to solidify the resultant reaction product. The product is preferably ground to a fine powder and dispersed in a medium including a binder so that it can be coated onto a support for use as a developer layer. Alternatively, the molten liquid can be dispersed directly into an aqueous dispersion medium under agitation.

The first component of the developer material esterfied or hydrolyzed styrene-maleic anhydride copolymer (while the copolymer is referred to as being esterfied or hydrolyzed, small amounts of maleic anhydride (e.g., less than about 10%) may be present). In practice, the ratio of styrene to maleic anhydride typically ranges from about 1 to 4 moles styrene to about 1 mole maleic anhydride. Further, the degree of hydrolysis of the copolymer typically ranges from about 95% to about 100%. Examples of commercially available esterfied or hydrolyzed styrene-maleic anhydride copolymers which may be utilized in accordance with the present invention include Atochem SMA 3840, Atochem SMA 1440, Atochem 17352 and Atochem 2625, all manufactured by Atochem of West Chester, PA.

The styrene-maleic anhydride copolymer itself is not a particularly efficient electron accepting developer material. To improve its developing capabilities the anhydride ring undergoes a ring opening reaction to provide more reactive developer groups to the copolymer. For example, the ring may undergo esterfication by reaction with an alcohol such as methanol to provide reactive carboxylic acid groups and ester groups. A preferred degree of esterfication is approximately 35% to about 50%.

The second component of the developer material comprises an acid capable of reacting with a chromogenic electron donating colorless precursor to form a visible image. Particularly preferred acids include organic compounds having at least one carboxyl group and include aliphatic carboxylic acids and aromatic acids. Most preferred are acids which have a maximum of three carboxyl groups and from about 5 to about 20 carbon atoms. Metal salts of organic acids may also be utilized in the present invention.

Specific examples of organic carboxylic acids useful in the present invention, include formic acid, acetic acid, caproic acid, heptanoic acid, caprylic acid, pelargonic acid, capric acid, n-undecylenic acid, lauric acid, n-dodecylenic acid, myristylenic acid, n-pentadecylenic acid, margaric acid, stearic acid, n-nonadecylenic acid, arachidic acid, heneicosanoic acid, behenic acid, n-tricosanoic acid, lignoceric acid, n-pentacosanoic acid, cerotic acid, n-heptacosanoic acid, montanic acid, n-nonacosanoic acid, melissic acid, n-hentriacontanoic acid, n-dotriacontanoic acid, n-tetratriacontanoic acid, ceroplastic acid, n-hexatriacontanoic acid, n-octatriacontanoic acid, n-hexatetracontanoic acid, oleic acid, linolenic acid, linoleic acid, stearolic acid, alpha-chlorolauric acid, alpha-chlorostearic acid, alpha-bromomyristic acid, 1,8-octanedicarboxylic acid, 1,12-dodecanedicarboxylic acid, 2,4-decanedienoic acid, 2-hydroxy-2,4-dimethylpentanoic acid, o-toluic acid, m-toluic acid, p-toluic acid, benzoic acid, o-chlorobenzoic acid, m-chlorobenzoic acid, p-chlorobenzoic acid, o-bromobenzoic acid, p-nitrobenzoic acid, salicylic acid, o-chlorosalicylic acid, m-hydroxysalicylic acid, p-hydroxysalicylic acid, anisic acid, gallic acid, phthalic acid, trimellitic acid, diphenic acid, phenylacetic acid, alpha-phenyl-n-valerianic acid, p-isopropylbenzoic acid, 2,4-cresotinic acid, 5-methylsalicylic acid, 5-tert-butylsalicylic acid, 3,5-di-sec-butylsalicylic acid, 3,5-di-sec-butylsalicylic acid, 3-methyl-5-tert-butylsalicylic acid, 3,5-di-tert-butylsalicylic acid, 5-isoamylsalicylic acid, 3-phenylsalicylic acid, 5-cyclohexylsalicylic acid, and the like. A partialy preferred organic acid is salicylic acid.

Metals forming a metal salt with the organic carboxylic acids include sodium, lithium, potassium, magnesium, calcium, zinc, cadmium, aluminum, tin, lead, chromium, manganese, cobalt, nickel, and the like. There is no overly critical aspect to the selection of the exact metal used, i.e., substantially all metal salts are useful. A particularly preferred metal salt comprises zinc salicylate.

It is further contemplated that mixtures of various organic acids and metal salts may be utilized in the present invention. For example, for certain applications one may wish to utilize two or more organic carboxylic acids with two or more types of metal salts to obtain a certain effect. Particularly good results may be obtained when utilizing a combination of salicylic acid and zinc salicylate.

In practice the ratio of styrene-maleic anhydride copolymer to organic acid typically ranges from about 95 to 50 parts copolymer to about 5 to 50 parts organic acid or metal salt thereof. For example, suitable results have been produced when utilizing a mixture containing 75 parts styrene-maleic anhydride copolymer and 25 parts organic acid or metal salt derivative thereof.

Once the styrene-maleic anhydride copolymer and organic acid and/or metal salt thereof have been mixed together, they are heated together until they form a single phase, high viscosity molten liquid. In practice, the mixture is heated to a temperature ranging between about 100°C and about 200°C and more preferably between about 150°C and about 180°C. It is critical to the success of the present invention that the materials be melted together to form a molten liquid. As shown in the Examples, the melting of the materials enables a developer material having improved properties, particularly superior coatability at high levels of solids and uniform density of developer material to be produced.

After the materials have been melted together, they are mixed in a molten state for an extended period of time. For example, the mixture may be maintained in a molten state for a period of time ranging from about 2 seconds to about 30 minutes. This process can be done either on a continuous or batchwise basis. Mixing times for batchwise procedures tend to be longer. Thereafter, the molten liquid is solidified by cooling.

To produce a developer sheet using the developer material of the present invention, the material, typically having a partial size of about 2 to about 10 microns, is dispersed in a coating liquid, for example water, and coated onto a support. Other additives present in the coating liquid may include binders, surfactants, dispersants, antifoam agents, colloid stabilizers, ultraviolet absorbers and antioxidants.

Any of the binders which are typically utilized for coating a solid developer material onto a substrate may be selected for use in accordance with the present invention. Examples include synthetic materials such as styrene-butadiene latex and polyvinyl alcohol, and natural materials such as casein, gum arabic, gelatin, etc. A particularly preferred binder material is polyvinyl alcohol. Because of the adhesive properties of styrene-maleic anhydride copolymer resins, an additional binder may not be required in the coating formulation. When present, the binder is preferably added in an amount ranging from about 0.5 to about 6 parts per 100 parts of developer material, and more preferably between about 2 and 4 parts per 100 parts developer material.

The developer coating formulation may additionally include a surfactant material to aid in the coating of the formulation onto the substrate. In some instances, when utilizing a transparent substrate, the surfactant may actually aid in transparentizing the final image after development. A particularly useful class of surfactants comprises dialkyl esters of sulfodicarboxylic acids, with sodium dioctyl sulfosuccinate being a particularly preferred surfactant. This compound is commercially available from American Cyanamid under the trade name Aerosol OT-75. Other surfactants, such as Aerosol 22 and Aerosol 3030, manufactured by American Cyanamid, as well as commercially available fluorocarbon surfactants may be added.

Another type of additive which may be added to the formulation is an ultraviolet absorber. Examples of ultraviolet absorbers include hydroxyphenylbenzotriazoles. Examples of these absorbers are disclosed in commonly assigned U.S. Patent Application Serial No. 184,735, filed April 22, 1988. An example of a commercially available hydroxyphenylbenzotriazole is Ciba Geigy's Tinuvin 328.

Antioxidants may also be added to the coating formulation. Examples of these include hindered phenolic antioxidants. A commercially available antioxidant is Irganox 1010, manufactured by Ciba Geigy. For most applications, the addition of the ultraviolet absorber and antioxidant may help in stabilizing the yellow dye of the imaged sheet.

Once the developer material and other optional additives are dispersed in a coating liquid, the liquid is coated onto a substrate to form a developer sheet. Paper and transparent polymeric substrates are particularly preferred substrate materials. The developer coating liquid is applied to the surface of the support using methods known in the art in an amount ranging from about 6 to 18 g/m$^2$ dry weight. Due to the low viscosity of the coating formulation, high levels of solids may be added to the dispersion coating solvent. Levels of solids ranging between about 40 to about 70% may be achieved in accordance with the present invention.

To produce a visible image using the developer sheet of the present invention, it is brought into contact with an electron donating chromogenic color-forming agent. The color-forming agent is typically maintained in pressure rupturable microcapsules.

Representative examples of suitable color formers include substantially colorless compounds having in their partial skeleton a lactone, a lactam, a sulfone, a spiropyran, an ester or an amido structure such as triarylmethane compounds, bisphenylmethane compounds, xanthene compounds, fluorans, thiazine compounds, spiropyran compounds and the like. Crystal Violet Lactone, Copikem X, IV and XI (products of Hilton-Davis Co.) and commercially available cyan, yellow and magenta color forming agents are often used alone or in combination as color precursors in the present invention.

In accordance with a preferred embodiment, the pressure rupturable microcapsules are also photosensitive and are maintained as a layer on a support, forming an imaging sheet. The imaging sheet, as well as the photosensitive compositions, photoinitiators, color formers, wall formers, encapsulation techniques and developer materials described in U.S. Patent Nos. 4,399,209; 4,772,530; and 4,772,541 to The Mead Corporation are useful herein.

To form a visible image, the imaging sheet including the layer of microcapsules containing a photosensitive composition in the internal phase is image-wise exposed to actinic radiation. In the most typical embodiments, the photosensitive composition is a photopolymerizable composition including a polyethylenically unsaturated compound and a photoinitiator and is encapsulated with the color former. The image-wise exposure hardens the internal phase of the microcapsules. Following exposure, the imaging sheet is assembled with the developer sheet of the present invention and the assembly is subjected to a uniform rupturing force by passing the sheets through the nip between a pair of pressure rollers. Upon passing through the pressure rollers, the microcapsules image-wise rupture and release their internal phase whereupon the color former migrates to the developer sheet and forms an image. The imaging system can be designed to produce monochromatic or polychromatic full color images.

After the reaction has occurred between the color-forming agent and the developer material, the developer sheet may be heated and/or subjected to pressure to cause the developer material to coalesce into a thin transparent continuous film. In the case where a paper material is used as the developer sheet support a glossy image is produced whereas in the case where a transparent polymeric film support is used as the substrate the developer material will transparentize. The film forming capability of the developer material results from the material having a gloss temperature less than 150°C. The gloss temperature of the developer material typically ranges between about 120°C and about 150°C.

The present invention is illustrated in more detail by the following non-limiting examples.

Comparative Example 1

The following compounds were mixed together to form a developer coating formulation.

| Component | % Dry |
|---|---|
| Atochem SMA 3840 | 65.6 |
| Zinc salicylate | 28.1 |
| Aerosol OT-75 | 0.5 |
| Aerosol NPES 3030 | 0.5 |
| Colloid 681F | 0.5 |
| Tinuvin 328 | 1.4 |
| Irganox 1010 | 1.4 |
| PVA 205 (polyvinyl alcohol) | 2.0 |

The formulation (48% solids having a mean particle size of 3.8 microns) was coated onto a paper support using a Meyer rod to a coat weight of about 13.4 g/m² to form a developer sheet. A brookfield LVT viscometer was used to measure the viscosity of the coating formulation. Viscosity measured was 155 cps at 60 RPM. As a result, it was very difficult to coat this composition onto the paper support.

Example 2

The above experiment was repeated with the exception that the SMA 3840 and zinc salicylate were blended, were heated to about 150 to 180°C to form a molten liquid, and cooled to form a single phase solid material. The solid was ground to a fine powder, mean particle size of 3.8 microns and coated onto a paper using a number 22 Meyer rod. The percent solids of the coating was 48%, and the measured viscosity was 28 cps at 60 RPM. As a result, the coating formulation was much more easily coated onto the support.

As demonstrated by the above examples, it is theorized that if the styrene maleic anhydride resin and the zinc salicylate are blended together in the dispersion process, the two materials are competing for dispersing agent and/or surfactant. This results in a poorly dispersed system and the resulting increased viscosity. However, if the materials are melt blended prior to dispersion, the surfaces of all of the particles in the dispersion are approximately the same, and there is therefore no competition for dispersing agent and/or surfactant. The resulting coating formulation is well dispersed and has a much lower viscosity. When the styrene maleic anhydride resin and the zinc salicylate are blended together in the dispersion without melting, the zinc salicylates tends to settle out, causing grit problems. By comparison, the formulation which is melt blended does not demonstrate such problems. It is proposed that this phenomenon occurs as a result of the particles having been melted together and thoroughly mixed to result in one material of uniform density. When this material is ground and dispersed into fine particles in the proposed micron range, all of the particles have an approximate uniform density, and thereby tend to result in a more stable dispersion.

In short, the coating rheology obtained by melting the materials together prior to coating enables the formulation of developer coatings have a very high level of solids. By comparison, without melting the materials prior to coating it is impossible to coat these materials at high solids levels due to the higher

6

viscosity.

Having described the invention in detail and by reference to preferred embodiments thereof, it will be apparent that modifications and variations are possible without departing from the scope of invention defined in the appended claims.

## Claims

1. A developer material produced by the process comprising the steps of:
   mixing and melting together a developer composition comprising esterfied or hydrolyzed styrene-maleic anhydride copolymer and an organic acid or metal salt thereof capable of reacting with a chromogenic electron donating colorless precursor to form a visible image;
   cooling said melted mixture to form a solid material; and
   dispersing said solid material in a coating solvent.

2. The material according to claim 1 wherein said composition comprises said organic acid and a metal salt of said organic acid.

3. The material according to claim 1 wherein said organic acid comprises a carboxylic acid.

4. The material according to claim 3 wherein said carboxylic acid comprises salicylic acid or a salicylic acid derivative.

5. The material according to claim 2 wherein said organic acid comprises salicylic acid and wherein said metal salt comprises zinc salicylate.

6. The material according to claim 1 wherein said composition further comprises an ultraviolet absorber.

7. The material according to claim 1 wherein said composition further comprises an antioxidant.

8. The material according to claim 1 further comprising a binder, and wherein said solid material is dispersed a liquid including said binder.

9. The material according to claim 1 wherein said material has a gloss temperature less than $150^\circ$ C.

10. The material according to claim 1 wherein the amount of solids ranges from about 40% to about 70%.

11. A developer sheet comprising a support having a layer of a color developer material on the surface thereof, said color developer material being produced by the process comprising the steps of:
    mixing and melting together a developer composition comprising esterfied or hydrolyzed styrene-maleic anhydride copolymer and an organic acid or metal salt thereof capable of reacting with a chromogenic electron donating colorless precursor to form a visible image;
    cooling said melted mixture to form a solid material; and
    dispersing said solid material in a coating solvent.

12. The developer sheet according to claim 11 wherein said developer composition comprises said organic acid and a metal salt of said organic acid.

13. The developer sheet according to claim 11 wherein said organic acid comprises a carboxylic acid.

14. The developer sheet according to claim 13 wherein said carboxylic acid comprises salicylic acid or a salicylic acid derivative.

15. The developer sheet according to claim 12 wherein said organic acid comprises salicylic acid and wherein said metal salt comprises zinc salicylate.

16. The developer sheet according to claim 11 wherein said developer composition further comprises an ultraviolet absorber.

**17.** The developer sheet according to claim 11 wherein said composition further comprises an antioxidant.

**18.** The developer sheet according to claim 11 wherein said developer composition is dispersed in a binder.

**19.** The developer sheet according to claim 11 wherein the amount of solids ranges from about 40% to about 70%.

**20.** A process for forming images comprising the step of image-wise transferring a chromogenic colorless electron donating color forming agent to a developer sheet having a layer of a color developer material capable of reacting with said color forming agent to form a visible image on the surface thereof, said color developer material being produced by the process comprising the steps of:

mixing and melting together a developer composition comprising esterfied or hydrolyzed styrene-maleic anhydride copolymer and an organic acid or metal salt thereof capable of reacting with a chromogenic electron donating colorless precursor to form a visible image;

cooling said melted mixture to form a solid material; and

dispersing said solid material in a dispersion coating solvent

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y | US-A-4 046 941   (T.SAITO ET AL.)<br>* column 8, lines 55 - 65 * * column 9, lines 16 - 20 @ column 10, lines 29 - 35 @ column 16, line 45 *<br>— — — | 1-20 | B 41 M<br>5/155<br>G 03 F 7/00 |
| Y,D | US-A-3 874 895   (T.HAYASHI ET AL.)<br>* column 4, line 20 - column 49 *<br>— — — | 1-20 | |
| Y | US-A-4 165 103   (J.R.BODMER)<br>* column 2, line 51 - column 3, line 2 *<br>— — — | 1-20 | |
| A | US-A-4 025 490   (F.D.WEAVER)<br>* the whole document *<br>— — — | 1-20 | |
| A | FR-A-2 350 205   (THE MEAD CORPORATION)<br>* page 7, line 31 - page 8, line 11; claims 5, 6 *<br>— — — — — | 1-20 | |

TECHNICAL FIELDS
SEARCHED (Int. Cl.5)

B 41 M
G 03 F

The present search report has been drawn up for all claims

| Place of search | Date of completion of search | Examiner |
|---|---|---|
| The Hague | 06 April 91 | BACON,A.J. |